# EUROPÄISCHE PATENTANMELDUNG

(11) **EP 1 655 358 A1**
(43) Veröffentlichungstag der Anmeldung: **10.05.2006**
(21) Anmeldenummer: 04026210.7
(22) Anmeldetag: 04.11.2004
(51) Int. Cl.: C09K 5/04

(54) **Arbeitsfluid zur Wärmeübertragung**

(71) Anmelder: Solvay Fluor GmbH, 30173 Hannover (DE)
(72) Erfinder: Schwiegel, Martin Dipl. Ing., 30167 Hannover (DE)
(74) Vertreter: Kulik, Angelika

(57) **Zusammenfassung**

Arbeitsfluid zur Wärmeübertragung insbesondere zur Wärmeübertragung mittels Wärmerohren enthaltend oder bestehend aus teil- und/oder perfluorierten Kohlenwasserstoffen und/oder perfluorierten Polyethern.

Vorzugsweise wird ein Gemisch aus Pentafluorbutan und perfluorierten Polyether als Arbeitsfluid eingesetzt.

## Beschreibung

Die Erfindung betrifft ein Arbeitsfluid zur Wärmeübertragung, insbesondere ein Arbeitsfluid für Wärmerohre.

Als Wärmerohr oder Heatpipe wird eine vornehmlich in einer Richtung wärmetransportierende Vorrichtung bezeichnet, bei der die Verdampfungswärme einer Flüssigkeit für den Wärmetransport ausgenutzt wird. Die Flüssigkeit wird am heißen Ende des Wärmerohres verdampft und am kälteren Ende wieder kondensiert. Üblicherweise wird eine Heatpipe durch ein hermetisch verschlossenes Rohr gebildet, das eine geringe Menge einer leicht siedenden Flüssigkeit, das Arbeitsfluid, enthält. Der untere Bereich des Rohres wird mit dem Wärmeüberschußbereich, beispielsweise mit dem zu kühlenden Bauelement in Kontakt gebracht und somit erwärmt. Dadurch verdampft die im Rohr enthaltende Flüssigkeit und der Dampf gelangt aufsteigend in den oberen Bereich des Rohres, dem Wärme entzogen wird, wobei die Flüssigkeit kondensiert und auf Grund der Schwerkraft wieder in den unteren Bereich des Rohres zurückgelangt.

Die Heatpipe kann sowohl horizontal als auch vertikal angeordnet sein. Schräggestellte Heatpipes sind ebenfalls bekannt. Der Einbau oder die Anordnung der Heatpipes ist abhängig von dem jeweiligen Anwendungsfall. Der Rücktransport des Kondensates kann also in Abhängigkeit von der Anordnung des Rohres sowohl durch Schwerkraft erfolgen, sofern ein Gefälle besteht oder, sofern kein Gefälle vorhanden ist auch ohne Schwerkraft, durch Kapillarkräfte. Zur Verbesserung des Rücktransportes des Arbeitsfluides werden in diesem Fall üblicherweise z.B. poröse Schichten, wie Sintermetallschichten, oder Mikrostrukturen an der Rohrinnenwand angeordnet.

Der Anwendungsbereich für den Einsatz von Wärmerohren ist nicht auf bestimmte Einsatzgebiete eingeschränkt. Neuere Entwicklungen zeigen, daß auf Grund der Minimierung der Bauteilgröße der Wärmerohre, diese einen verstärkten Einsatz in der Elektronikindustrie finden.

Die Kühlung von Elektronikbauelementen kann bekanntermaßen auf unterschiedliche Art und Weise gelöst werden. Die einfachste Ausführung zur Kühlung erfolgt mittels Ventilatoren, die in Schaltschräriken eingebaut sind. Zur Unterstützung des Wärmeüberganges werden auch häufig Kühlkörper mit großen gerippten Oberflächen, gegebenenfalls mit integrierten Ventilatoren eingesetzt. Zur Kühlung von Bauteilen in der Leistungselektronik müssen massive Kühlkörper aus Kupfer oder Aluminium eingesetzt werden, die bis zu 30 mm Wandstärke besitzen können. Dadurch erhalten die Baukörper ein hohes Gewicht und ein großes Bauvolumen, was ein erheblicher Nachteil bei der Gerätekonstruktion ist. Auf Grund der begrenzten Kühlwirkung solcher massiver Kühlkörper führen große Verlustwärmeströmungen zu einem deutlichen Anstieg der Bauteiltemperaturen, was wiederum erhöhte Ausfallraten und schlechtere Wirkungsgrade der Bauteile verursacht.

Wasserumlaufkühlungen, bei denen ein auf dem Prozessor angebrachter Kühlkörper von Wasser durchflossen wird, sind ebenfalls bekannt. Das Wasser wird hier durch eine Pumpe im Kreislauf gefördert und gibt seine aufgenommene Wärme beispielsweise über einen luftgekühlten Wärmetauscher an die Umgebung ab.

Die Wärmeabfuhr mittels Phasenwechselprozesse, wie Verdunstungs- und Verdampfungskühlung, ist ebenfalls bekannt. Hierbei kann eine maximale Wärmeabfuhr pro Flächeneinheit und damit verbunden eine erhebliche Platzeinsparung bei der Bauelementanordnung erzielt werden.

Die konstruktive Gestaltung der Kühleinrichtungen hängt entscheidend von der Art der Verdampfung - Blasensieden oder Konvektionssieden -, vom Druck und Temperaturbereich und vom eingesetzten Wärmeübertragungsfluid ab.

Der Erfindung liegt die Aufgabe zugrunde die Wärmeabfuhr von temperaturkritischen Bauteilen mittels eines Phasenwechselprozesses unter Verwendung von Wärmerohren, die mit effizient wirksamen Arbeitsfluiden als Wärmeübertragungsfluide arbeiten, zu gewährleisten.

Die Aufgabe wird dadurch gelöst, daß in einem Wärmerohr, vorzugsweise einer Heatpipe, als Arbeitsfluid oder Wärmeübertragungsfluid teilfluorierte und/oder perfluorierte Kohlenwasserstoffe und/oder teilfluorierte oder perfluorierte Polyether und/oder Polyether verwendet werden.

Als teil- und/oder perfluorierte Kohlenwasserstoffe sind z.B. fluorierte Alkane aus der Gruppe Pentafluorpropan, wie 1,1,1,3,3-Pentafluorpropan (HFC 245fa), 1,1,1,2,3-Pentafluorpropan (HFC 245eb), 1,1,2,2,3-Pentafluorpropan (HFC 245ca), Hexafluorpropan, wie 1,1,1,3,3,3-Hexafluorpropan (HFC 236fa), 1,1,2,3,3,3-Hexafluorpropan (HFC 236ea), 1,1,2,2,3,3-Hexafluorpropan (HFC 236ca), Heptafluorpropan , wie 1,1,1,2,3,3,3-Heptafluorpropan (HFC 227ea), Pentafluorbutan, wie 1,1,1,3,3-Pentafluorbutan (HFC 365mfc), Hexafluorbutan, wie 1,1,1,2,2,4-Hexafluorbutan (HFC 356mcf), Heptafluorbutan, wie 1,1,1,2,2, 4,4-Heptafluorbutan oder Decafluorpentan, wie 1,1,1,2,3,4,4,5,5,5-Decafluorpentan (HFC 43-10mee) als Einzelverbindung oder im Gemisch untereinander geeignet.

Die teil- oder perfluorierten Kohlenwasserstoffe können ebenfalls im Gemisch mit teil- oder perfluorierten Polyethern oder mit Polyethern erfindungsgemäß als Arbeitsfluid eingesetzt werden.

Geeignete perfluorierte Polyether werden z.B. in der WO 02/38718 beschrieben. Diese perfluorierten Polyether enthalten Kohlenstoff, Fluor und Sauerstoff, besitzen mindestens zwei, vorzugsweise drei C-O-C-Etherbindungen und haben ein Molekulargewicht von etwa 200 oder mehr und einen Siedepunkt oberhalb 40 °C bei 101,3 kPa. Diese Polyether sind herstellungsbedingt eine Mischung von Einzelsubstanzen und haben eine Viskosität im Bereich von 0,3 bis 1 cSt bei 25 °C.

Als bevorzugte Perfluorpolyether werden die von der Fa. Ausimont unter dem Namen GALDEN und FOMBLIN vermarkteten Produkte verwendet. Als Beispiele seien genannt:
GALDEN HT 55 : Sdpkt. 57 °C bei 101.3 kPa; Mol.Gew. 340
GALDEN HT 70 : Sdpkt. 66 °C bei 101,3 kPa; Mol.Gew. 410
FOMBLIN PFS1 : Sdpkt. 90 °C bei 101,3 kPa; Mol.Gew. 460

Aus der Vielzahl der genannten Verbindungen wurden in einer Ausführungsform die Einzelsubstanzen HFC 365 mfc und GALDEN HAT 55 als Arbeitsfluid eingesetzt.

In einer anderen Ausführungsform der Erfindung wurde als Wärmeübertragungsfluid ein Gemisch aus 1.1.1.3.3- Pentafluorbutan (HFC 365 mfc) und perfluoriertem Polyether (GALDEN HT55) mit einem Mischungsverhältnis von 65 zu 35 eingesetzt.

Die Menge des eingesetzten Fluids richtet sich nach der Größe des Kühlsystems.

Als effizient wirksame Wärmeübertragungsfluide im Sinne der Erfindung sind Verbindungen bevorzugt geeignet, die kaum oder nicht brennbar sind, eine optimierte Oberflächenspannung und eine hohe Verdampfungsenthalpie besitzen. Die Enthalpie des Fluids sollte einen so hohen Wert besitzen, damit bei kleiner Fluidmenge eine maximal hohe Ausbeute des Wärmetransportes erzielbar ist. Die Verbindungen sollten über einen hohen elektrischen Widerstand und eine hohe elektrische Durchschlagfestigkeit verfügen. Insbesondere für den Einsatz zur Kühlung von Elektronikbauteilen sollten die Fluide bei Zimmertemperatur einen Dampfdruck bei 1 bar besitzen und bei erreichter Arbeitstemperatur den Normaldruck nicht überschreiten, die Fluide sollten bei Umgebungsdruck und Umgebungstemperatur flüssig sein. Die Fluide sollten nicht toxisch sein, einen niedrigen GWP und möglichst einen ODP von Null aufweisen Die Viskosität der Fluide sollte möglichst niedrig sein.

Es wurde gefunden, daß die oben genannten Verbindungen oder deren Mischungen diesen Anforderungen genügen und deshalb geeignete Arbeitsfluide darstellen.

Die nachfolgenden Beispiele sollen die Erfindung erläutern jedoch nicht darauf einschränken.

### Beispiel 1 bis 3 :

Das von uns verwendete Kühlsystem bestand aus einem Verdampfer- und einem Kondensationsmodul. Beide Module sind über ein Steigrohr bzw. einen flexiblen Schlauch verbunden. Das System ist hermetisch abgeschlossen. Im System zirkuliert das Wärmeübertragungsfluid.

Als Verdampfermodul wurde eine Metallbox aus Kupfer verwendet, die mit den Arbeitsfluiden befüllt wurde. Auf der Rückseite des Moduls wurden die zu kühlenden Bauteile montiert. Das Verdampfermodul selbst wurde auf eine Heizplatte montiert, die bis 950 Watt durchgefahren wurde. An das aus der Verdampferbox herausführende Steigrohr wurde der Kondensator angeschlossen, der den Dampf des Arbeitsfluids verflüssigt.

Arbeitsfluid Beispiel 1 bis 3 :
1. HFC 365mfc/Galden HT 55 (65:35)
2. HFC 365mfc
3. Galden HT 55

Die in der Tabelle aufgezeigten Ergebnisse zeigen die Wirksamkeit der erfindungsgemäß eingesetzten Arbeitsfluide.

Als Vorteil der erfindungsgemäßen Arbeitsfluide ist besonders zu erwähnen, daß insbesondere die Gemische, die HFC 365mfc enthalten, nicht entflammbar, elektrisch isolierend und umweltverträglich sind. Als weiterer Vorteil ist der zeotrope Charakter derartiger Gemische anzusehen.

**Tabelle:**

| **Leistung Q [W]** | **T**_{**Bauteil**} **[°C] R365mfc/Galden HT55** | **T**_{**Bauteil**} **[°C] R365mfc** | **T**_{**Bauteil**} **[°C] Galden HT55** |
|---|---|---|---|
| 60 | 34 | 35 | 55,5 |
| 100 | 36 | 37 | 59 |
| 200 | 38,5 | 40 | 60 |
| 300 | 41 | 42 | 63,5 |
| 400 | 44 | 44,5 | 65 |
| 500 | 46 | 47 | 67 |
| 600 | 49 | 50 | 70 |
| 700 | 52 | 53 | 73 |
| 800 | 55 | 55 | 76,5 |
| 900 | 57,5 | 57,5 | 100 |

## Patentansprüche

1. Arbeitsfluid zur Wärmeübertragung insbesondere zur Wärmeübertragung mittels Wärmerohren enthaltend oder bestehend aus teil- und/oder perfluorierten Kohlenwasserstoffen und/oder teil- oder perfluorierten Polyethern und/ oder Polyethern.

2. Arbeitsfluid nach Anspruch 1, **dadurch gekennzeichnet, daß** als teil- oder perfluorierte Kohlenwasserstoffe Verbindungen aus der Gruppe Pentafluorpropan, wie 1,1,1,3,3-Pentafluorpropan, 1,1,1,2,3-Pentafluorpropan, 1,1,2,2,3-Pentafluorpropan, Hexafluorpropan, wie 1,1,1,3,3,3-Hexafluorpropan, 1,1,2,3,3,3-Hexafluorpropan, 1,1,2,2,3,3-Hexafluorpropan, Heptafluorpropan, wie 1,1,1,2,3,3,3-Heptafluorpropan, Pentafluorbutan, wie 1,1,1,3,3-Pentafluorbutan, Hexafluorbutan, wie 1,1,1,2,2,4-Hexafluorbutan, Heptafluorbutan, wie 1,1,1,2,2,4,4-Heptafluorbutan oder Decafluorpentan, wie 1,1,1,2,3,4,4,5,5,5-Decafluorpentan als Einzelverbindung oder im Gemisch untereinander enthalten sind.

3. Arbeitsfluid nach Anspruch 1, **dadurch gekennzeichnet, daß** perfluorierte Polyether mit mindestens zwei C-O-C-Etherbindungen und einem Molekulargewicht von etwa 200 und einem Siedepunkt oberhalb 40 °C bei 101,3 kPa enthalten sind.

4. Arbeitsfluid nach Anspruch 1, **dadurch gekennzeichnet, daß** es 1.1.1.3.3 - Pentafluorbutan und einen perfluorierten Polyether mit einem Molekulargewicht von 340 enthält oder daraus besteht.

5. Arbeitsfluid nach Anspruch 4, **gekennzeichnet durch** ein Mischungsverhältnis Pentafluorbutan zu Polyether von 65:35.
